(19) Europäisches Patentamt / European Patent Office / Office européen des brevets

(11) **EP 1 720 171 B1**

(12) **FASCICULE DE BREVET EUROPÉEN**

(45) Date de publication et mention
de la délivrance du brevet:
**28.01.2009 Bulletin 2009/05**

(51) Int Cl.:
*G11C 19/28* (2006.01)          *G06F 5/01* (2006.01)

(21) Numéro de dépôt: **06113466.4**

(22) Date de dépôt: **03.05.2006**

(54) **Dispositif de décalage en anneau**

Ringschieberegister

Ring phase shift device

(84) Etats contractants désignés:
**DE FR GB IT**

(30) Priorité: **04.05.2005 FR 0551182**

(43) Date de publication de la demande:
**08.11.2006 Bulletin 2006/45**

(73) Titulaire: **ST MICROELECTRONICS S.A.**
**92120 Montrouge (FR)**

(72) Inventeurs:
• **Paumier Laurent**
**38000 Grenoble (FR)**
• **Urard, Pascal**
**38570 Theys (FR)**

(74) Mandataire: **de Beaumont, Michel**
**1bis, rue Champollion**
**38000 Grenoble (FR)**

(56) Documents cités:
**WO-A-20/04044731          US-B1- 6 449 328**

• **BRACKENBURY L E M ET AL: "UNIVERSAL SHIFT MATRIX" IEE PROCEEDINGS E. COMPUTERS & DIGITAL TECHNIQUES, INSTITUTION OF ELECTRICAL ENGINEERS. STEVENAGE, GB, vol. 137, no. 1, PART E, janvier 1990 (1990-01), pages 57-64, XP000094938 ISSN: 0143-7062**

**Description**

Domaine de l'invention

La présente invention concerne un dispositif de décalage en anneau de symboles.

Exposé de l'art antérieur

Un exemple d'application d'un dispositif de décalage en anneau concerne le décodage de symboles transmis selon la norme DVB-S2 en utilisant un code de correction d'erreur du type à matrice de parité creuse (code LDPC de l'anglais Low Density Parity Check code).

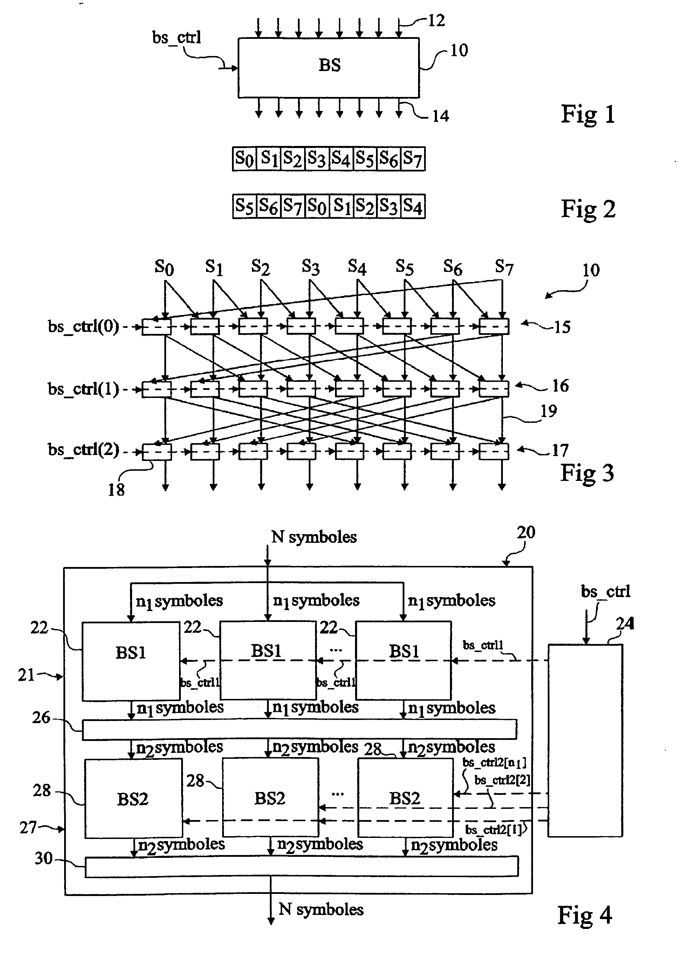

La figure 1 représente schématiquement un dispositif de décalage en anneau 10 (BS) recevant en parallèle N symboles 12 disposés selon un ordre particulier, chaque symbole correspondant à un message numérique codé sur un nombre nbit_data déterminé de bits. Le dispositif 10 fournit en parallèle N symboles 14, correspondant aux N symboles 12 reçus, auxquels a été appliqué un décalage avec rebouclage vers la gauche ou vers la droite d'un nombre de positions pouvant être choisi entre 0 et N-1. Le dispositif de décalage en anneau 10 reçoit un signal de commande bs_ctrl à partir duquel est déterminé le nombre de positions de décalage à appliquer aux symboles 12 reçus.

La figure 2 représente un exemple d'opération de décalage appliquée à huit symboles $S_0$ à $S_7$. Sur la ligne supérieure, on a représenté un exemple de disposition des symboles $S_0$ à $S_7$ tels que reçus par le dispositif de décalage en anneau 10 et, sur la ligne inférieure, on a représenté la disposition des symboles fournis par le dispositif 10 après application d'un décalage avec rebouclage (décalage en anneau) vers la droite de trois positions (ce qui équivaut à un décalage avec rebouclage vers la gauche de cinq positions).

La figure 3 représente un exemple de réalisation classique d'un dispositif 10 de décalage en anneau recevant huit symboles et adapté à réaliser un décalage avec rebouclage vers la droite de 0 à 7 positions. Le dispositif 10 comprend trois étages 15, 16, 17 de multiplexeurs. Chaque bloc 18 représente un module de multiplexage recevant deux symboles et fournissant l'un des deux symboles reçus et constitué de nbit_data multiplexeurs. Chaque trait continu fléché 19 correspond à un trajet emprunté par un symbole, c'est-à-dire, en pratique, à des pistes ou à des fils de connexion permettant la transmission de nbit_data bits. Les multiplexeurs des premier, deuxième et troisième étages 15, 16, 17 sont respectivement commandés par des signaux de commande bs_ctrl(0), bs_ctrl(1), et bs_ctrl(2).

Un tel dispositif de décalage en anneau est dit à structure logarithmique puisque chaque étage de multiplexeurs permet la réalisation d'un décalage avec rebouclage d'un nombre de positions égal à une puissance croissante de 2. En effet, le premier étage 15 permet la réalisation d'un décalage avec rebouclage vers la droite d'une position ($2^0$), le deuxième étage 16 permet la réalisation d'un décalage avec rebouclage vers la droite de deux positions ($2^1$) et le troisième étage 17 permet la réalisation d'un décalage avec rebouclage vers la droite de quatre positions ($2^2$). Par une combinaison de la valeur des bits de commande bs_ctrl(0), bs_ctrl(1), et bs_ctrl(2), n'importe quel décalage de 0 à 7 positions peut être réalisé.

De façon générale, un dispositif de décalage en anneau 10 à structure logarithmique recevant N symboles nécessite, pour réaliser un décalage avec rebouclage quelconque de 0 à N-1 positions, $\text{ceil}(\log_2(N))$ étages de multiplexeurs où $\log_2(N)$ est le logarithme en base 2 de N et $\text{ceil}(\log_2(N))$ est l'entier juste supérieur à $\log_2(N)$. Un tel dispositif 10 comprend donc $N*\text{nbit\_data}*\text{ceil}(\log_2(N))$ multiplexeurs. La structure logarithmique permet de minimiser le nombre de multiplexeurs nécessaire pour réaliser une opération de décalage.

Lors de la fabrication d'un dispositif de décalage en anneau, on utilise généralement des outils de conception assistés par ordinateur qui indiquent la surface qui serait théoriquement suffisante pour disposer les multiplexeurs en tenant compte des distances de séparation minimales à prévoir entre chaque multiplexeur et la surface réellement nécessaire pour disposer les multiplexeurs et les fils ou pistes de connexion entre ces derniers. La différence entre les deux surfaces est appelée dépassement de surface (en anglais overhead).

Une difficulté lors de la fabrication d'un dispositif de décalage en anneau à structure logarithmique provient de la grande irrégularité des longueurs des trajets 19 et du nombre important de croisements entre trajets 19 quelle que soit la disposition retenue pour les multiplexeurs. Ceci entraîne une forte augmentation du dépassement de surface lorsque le nombre de symboles et/ou le nombre de bits par symboles deviennent importants. A titre d'exemple, pour un décodeur d'un code LDPC, le produit N*nbit_data peut être supérieur à 2000. Le dépassement de surface peut alors être supérieur à 300 % pour un dispositif de décalage en anneau à structure logarithmique. Il en résulte l'obtention de dispositifs de décalage en anneau très encombrants.

Un autre inconvénient provient du fait qu'une augmentation de la surface du dispositif de décodage en anneau entraîne une augmentation de la longueur d'au moins certains des trajets empruntés par les symboles. Or, la durée de transmission d'un symbole sur un trajet dépend de la longueur du trajet. Si la durée de transmission des symboles (ou au moins de certains d'entre eux) est trop importante, il peut ne pas être possible de réaliser une opération de décalage en un cycle de l'horloge qui commande le fonctionnement du dispositif de décalage en anneau. Il est alors nécessaire de prévoir, entre des étages du dispositif de décalage en anneau, des éléments de mémorisation (par exemple des bascules) de façon à réaliser une opération de décalage en plusieurs cycles d'horloge. L'ajout d'éléments de mémorisation contribue à l'augmentation de la surface occupée par le dispositif de décalage en anneau.

Dans certains cas, un cercle vicieux peut se produire dans lequel l'ajout d'éléments de mémorisation entraîne une augmentation de la longueur des trajets empruntés par les symboles telle que des éléments de mémorisation supplémentaires sont à prévoir... Il peut alors être nécessaire d'imposer une durée minimale de cycle d'horloge en deçà de laquelle on ne peut pas réaliser un dispositif de décalage en anneau à structure logarithmique ayant des dimensions acceptables.

Résumé de l'invention

La présente invention vise un dispositif de décalage en anneau pour lequel le dépassement de surface est réduit.

Un autre objet de la présente invention est de prévoir un dispositif de décalage en anneau pouvant être mis en oeuvre avec un nombre de multiplexeurs égal ou légèrement supérieur au nombre de multiplexeurs d'un dispositif de décalage en anneau à structure logarithmique.

Le préambule de la revendication 1 est basé sur BRACKENBURY L E M; WELLS P J; GOSLING J B; "UNIVERSAL SHIFT MATRIX"; IEE PROCEEDINGS E. COMPUTERS & DIGITAL TECHNIQUES, INSTITUTION OF ELECTRICAL ENGINEERS, STEVENAGE, GB; ISSN 0143-7062; VOL 137; 1, PART E; pages 57-64.

Pour atteindre ces objets, la présente invention prévoit un dispositif de décalage en anneau adapté à recevoir un nombre N de symboles en parallèle, répartis en un nombre $n_2$ de groupes distincts d'un nombre $n_1$ de symboles, et à appliquer un décalage total en anneau aux N symboles d'un nombre déterminé de positions, le dispositif comprenant :

$n_2$ premiers dispositifs de décalage en anneau, chaque premier dispositif étant adapté à recevoir l'un des groupes distincts de $n_1$ symboles et à appliquer un premier décalage en anneau audit groupe de $n_1$ symboles, le premier décalage dépendant du décalage total ;

un module de réarrangement adapté à recevoir les N symboles fournis par les premiers dispositifs et à fournir N symboles répartis, de façon déterminée, en $n_1$ ensembles distincts de $n_2$ symboles ; et

$n_1$ seconds dispositifs de décalage en anneau, chaque second dispositif étant adapté à recevoir l'un des ensembles distincts de $n_2$ symboles et à appliquer un second décalage en anneau audit ensemble de symboles, le second décalage dépendant du décalage total; et

un module de commande adapté à recevoir un signal bs_ctrl représentatif du décalage total et à fournir, à chaque premier dispositif, un signal bs_ctrl1 représentatif du premier décalage qui dépend du décalage total et qui est identique pour chaque premier dispositif, et adapté à fournir, à chaque second dispositif, un signal bs_ctrl2 représentatif du second décalage qui dépend du décalage total et qui est identique pour chaque second dispositif, le dispositif comprenant, en outre, un module de permutation adapté à permuter aux moins deux symboles parmi les N symboles.

Selon un mode de réalisation de l'invention, le module de commande est adapté à fournir le signal bs_ctrl1 selon la relation suivante :

$$\texttt{bs\_ctrl1 = mod(bs\_ctrl,}n_1\texttt{)}$$

où mod(bs_ctrl,$n_1$ est le reste de la division entière de bs_ctrl par $n_1$, et adapté à fournir le signal bs_ctrl2 selon la relation suivante :

$$\texttt{bs\_ctrl2 = floor(bs\_ctrl/}n_1\texttt{)}$$

où floor(bs_ctrl/$n_1$) est le quotient de la division entière de bs_ctrl par $n_1$, le dispositif comprenant, en outre, un module de réarrangement auxiliaire adapté à recevoir les N symboles fournis par les seconds dispositifs et, pour un symbole reçu à une $i^{ème}$ position, à fournir ledit symbole à une $j^{ème}$ position selon la relation suivante :

$$\texttt{j = mod(i,}n_2\texttt{)*}n_1\texttt{ + floor(i/}n_2\texttt{)}$$

où i est un entier compris entre 0 et N-1, mod(i,$n_2$) est le reste de la division entière de i par $n_2$ et floor(i/$n_2$) est le quotient

de la division entière de i par $n_2$, le moyen de permutation (42) comprenant N modules de multiplexage (44), chaque module de multiplexage recevant un premier symbole à une position relative k, k étant un entier compris entre 1 et $n_1$, parmi les $n_1$ symboles fournis par un premier dispositif de décalage en anneau (22) et un second symbole à ladite position relative k parmi les $n_1$ symboles fournis par un premier dispositif de décalage en anneau (22) adjacent et fournissant le second symbole pour k inférieur ou égal à bs_ctrl1 et le premier symbole pour k strictement supérieur à bs_ctrl1.

Selon un mode de réalisation de l'invention, le module de commande est adapté à fournir le signal bs_ctrl11 selon la relation suivante :

$$\mathtt{bs\_ctrl1 = floor(bs\_ctrl/n_2)}$$

où floor(bs_ctrl/$n_2$) est le quotient de la division entière de bs_ctrl par $n_2$, et adapté à fournir le signal bs_ctrl2 selon la relation suivante :

$$\mathtt{bs\_ctrl2 = mod(bs\_ctrl,n_2)}$$

où mod(bs_ctrl,$n_2$) est le reste de la division entière de bs_ctrl par $n_2$, le dispositif comprenant, en outre, un module de réarrangement auxiliaire adapté à recevoir les N symboles et à fournir les N symboles aux premiers dispositifs de façon que, pour un symbole reçu à une $i^{ème}$ position, ledit symbole est fourni à une $j^{ème}$ position selon la relation suivante :

$$\mathtt{j = mod(i,n_2)*n_1 + floor(i/n_2)}$$

où i est un entier compris entre 0 et N-1, mod(i,$n_2$) est le reste de la division entière de i par $n_2$ et floor(i/$n_2$) est le quotient de la division entière de i par $n_2$, le moyen de permutation comprenant N modules de multiplexage, chaque module de multiplexage recevant un premier symbole à une position relative k, k étant un entier compris entre 1 et $n_2$, dans un groupe de $n_2$ symboles parmi les N symboles reçus par ledit dispositif et un second symbole à ladite position relative k dans un groupe adjacent de $n_2$ symboles et fournissant, au module de réarrangement auxiliaire, le premier symbole pour k inférieur ou égal à la différence entre $n_2$ et bs_ctrl2 et le second symbole pour k strictement supérieur à la différence entre $n_2$ et bs_ctrl2.

La présente invention prévoit également un décodeur de code comprenant des processeurs reliés à des éléments de mémorisation et à un dispositif de décalage en anneau tel que précédemment décrit, dans lequel les processeurs et les éléments de mémorisation sont disposés selon des premier et second anneaux concentriques et dans lequel les premiers ou les seconds dispositifs du dispositif de décalage en anneau sont répartis selon un troisième anneau concentrique aux premier et second anneaux.

Brève description des dessins

Ces objets, caractéristiques et avantages, ainsi que d'autres de la présente invention seront exposés en détail dans la description suivante d'exemples de réalisation particuliers faite à titre non-limitatif en relation avec les figures jointes parmi lesquelles :

la figure 1, précédemment décrite, représente les interfaces d'un dispositif classique de décalage en anneau ;
la figure 2, précédemment décrite, illustre un exemple de décalage réalisé par un dispositif de décalage en anneau ;
la figure 3, précédemment décrite, représente un dispositif classique de décalage en anneau à structure logarithmique ;
la figure 4 représente un exemple de réalisation d'un dispositif de décalage en anneau ;
les figures 5 à 7 représentent de façon plus détaillée des éléments du dispositif de décalage en anneau de la figure 4 ;
la figure 8 représente un exemple de dispositif de décalage en anneau adapté au traitement de douze symboles ;
la figure 9 illustre le fonctionnement du dispositif de la figure 8 ;
la figure 10 représente une variante de l'exemple de réalisation illustré en figure 4 ;
la figure 11 représente un premier exemple de réalisation d'un dispositif de décalage en anneau selon l'invention ;
la figure 12 illustre le fonctionnement du dispositif de la figure 10 ;
la figure 13 représente un second exemple de réalisation d'un dispositif de décalage en anneau selon l'invention ;

la figure 14 représente schématiquement un exemple de réalisation d'un décodeur LDPC utilisant un dispositif de décalage en anneau ;

la figure 15 représente schématiquement un exemple classique d'agencement des éléments du décodeur de la figure 14 utilisant un dispositif de décodage en anneau à structure logarithmique ; et

la figure 16 représente une figure analogue à la figure 15 pour un décodeur LDPC utilisant le dispositif de décalage en anneau selon l'invention.

<u>Description détaillée</u>

Par souci de clarté, de mêmes éléments ont été désignés par de mêmes références aux différentes figures.

La présente invention consiste à prévoir un dispositif de décalage en anneau recevant N symboles et comprenant au moins deux étages successifs comprenant chacun un nombre déterminé, éventuellement différent par étage, de dispositifs élémentaires de décalage en anneau, les dispositifs élémentaires du premier étage étant reliés aux dispositifs élémentaires du second étage. Chaque dispositif élémentaire de décalage en anneau reçoit seulement une partie des N symboles sur lesquels il réalise une opération de décalage. La présente invention permet de limiter la dispersion des longueurs et le nombre de croisements des trajets du dispositif de décalage en anneau, et donc de limiter le dépassement de surface du dispositif de décalage en anneau.

La figure 4 représente la structure générale d'un exemple de réalisation du dispositif de décalage en anneau 20. Le dispositif 20 reçoit N symboles, chaque symbole étant constitué de nbit_data bits, et fournit N symboles sur lesquels un décalage avec rebouclage (décalage en anneau) est réalisé. Les N symboles sont répartis en $n_2$ groupes de $n_1$ symboles, le premier groupe comprenant les $n_1$ premiers symboles des N symboles, le second groupe comprenant les $n_1$ symboles suivants, etc. Le dispositif 20 comprend un premier étage 21 de $n_2$ dispositifs élémentaires de décalage en anneau (BS1) 22. Chaque dispositif élémentaire 22 reçoit un groupe de $n_1$ symboles et effectue un décalage avec rebouclage vers la droite sur les $n_1$ symboles reçus d'un nombre de positions entre 0 et $n_1$-1 positions. Le dispositif de décalage en anneau 20 est commandé par un module de commande 24 qui reçoit un signal de commande bs_ctrl à partir duquel est fourni un même signal bs_ctrl1 à chaque dispositif élémentaire 22 représentatif du nombre de positions de décalage à réaliser par chaque dispositif élémentaire 22. Les $n_2$ groupes de $n_1$ symboles fournis par les $n_2$ dispositifs élémentaires 22 sont transmis à un étage de réarrangement 26 qui modifie, de façon déterminée, les positions des N symboles pour former $n_1$ groupes de $n_2$ symboles. Les $n_1$ groupes de $n_2$ symboles sont fournis à un second étage 27 de dispositifs élémentaires de décalage en anneau (BS2) 28. Chaque dispositif élémentaire 28 reçoit un groupe de $n_2$ symboles et effectue un décalage avec rebouclage vers la droite sur les $n_2$ symboles reçus d'un nombre de positions entre 0 et $n_2$-1 positions. Les dispositifs élémentaires 28 reçoivent des signaux de commande respectifs bs_ctrl2[1] à bs_ctrl2[$n_1$] fournis par le dispositif de commande 24 à partir du signal de commande bs_ctrl. Les dispositifs élémentaires 28 du second étage 27 de dispositifs élémentaires peuvent donc réaliser des décalages différents sur les groupes de $n_2$ symboles reçus. Les $n_1$ groupes de $n_2$ symboles fournis par les dispositifs élémentaires 28 sont transmis à un étage de réarrangement 30 qui modifie, de façon déterminée, les positions des N symboles. En pratique, les étages de réarrangement 26, 30 correspondent à une disposition particulière des trajets empruntés par les symboles.

Le signal bs_ctrl est un signal binaire représentatif du nombre de positions de décalage à réaliser par le dispositif 20.

Avec l'exemple de réalisation du dispositif de décalage en anneau 20 représenté en figure 4, on peut réaliser un décalage avec rebouclage vers la droite d'un nombre de positions donné par le signal bs_ctrl. Le signal de commande bs_ctrl1 est donné par la relation suivante :

$$\texttt{bs\_ctrl1} = \texttt{mod(bs\_ctrl,} n_1 \texttt{)}$$

où mod(bs_ctrl,$n_1$) est le modulo de bs_ctrl par $n_1$, c'est-à-dire le reste de la division entière de bs_ctrl par $n_1$. Chaque dispositif élémentaire 22 effectue alors un décalage vers la droite sur les $n_1$ symboles reçus de bs_ctrl1 positions.

Les signaux de commande bs_ctrl2[k], pour k entier compris entre 1 et $n_1$, sont donnés par les relations suivantes :

$$\texttt{bs\_ctrl2[k]} = \texttt{floor(bs\_ctrl/} n_1 \texttt{)} + 1 \quad \texttt{pour k} \leq \texttt{bs\_ctrl1}$$

$$\texttt{bs\_ctrl2[k]} = \texttt{floor(bs\_ctrl/} n_1 \texttt{)} \qquad \texttt{pour k} > \texttt{bs\_ctrl1}$$

où floor (bs_ctrl/$n_1$) est l'entier juste inférieur à bs_ctrl/$n_1$, c'est-à-dire la partie entière de bs_ctrl/$n_1$, autrement dit le quotient de la division entière de bs_ctrl par $n_1$.

Il apparaît donc que, pour le second étage 27 de dispositifs élémentaires, les bs_ctrl1 premiers dispositifs élémentaires 28 effectuent chacun un décalage avec rebouclage vers la droite de floor(bs_ctrl/$n_1$)+1 positions sur les $n_2$ symboles reçus et les $n_1$-bs_ctrl1 autres dispositifs élémentaires 28 effectuent chacun un décalage avec rebouclage vers la droite de floor (bs_ctrl/$n_1$) positions sur les $n_2$ symboles reçus.

Pour obtenir un décalage vers la gauche d'un nombre de positions donné par le signal bs_ctrl avec l'exemple de réalisation du dispositif 20 représenté en figure 4, il suffit de commander le dispositif 20 avec un signal bs_ctrl' égal à mod(N-bs_ctrl,N).

Chaque dispositif élémentaire 22, 28 peut être du type logarithmique. Chaque dispositif élémentaire 22 comprend alors $n_1$*nbit_data*ceil ($\log_2(n_1)$) multiplexeurs et chaque dispositif élémentaire 28 comprend $n_2$*nbit_data*ceil ($\log_2(n_2)$) multiplexeurs. Si on souhaite avoir un dispositif de décalage en anneau 20 comprenant le même nombre de multiplexeurs qu'un dispositif de décalage en anneau à structure logarithmique, les entiers $n_1$ et $n_2$ doivent vérifier la relation suivante :

$$\mathrm{ceil}(\log_2(n_1)) + \mathrm{ceil}(\log_2(n_2)) = \mathrm{ceil}(\log_2(N))$$

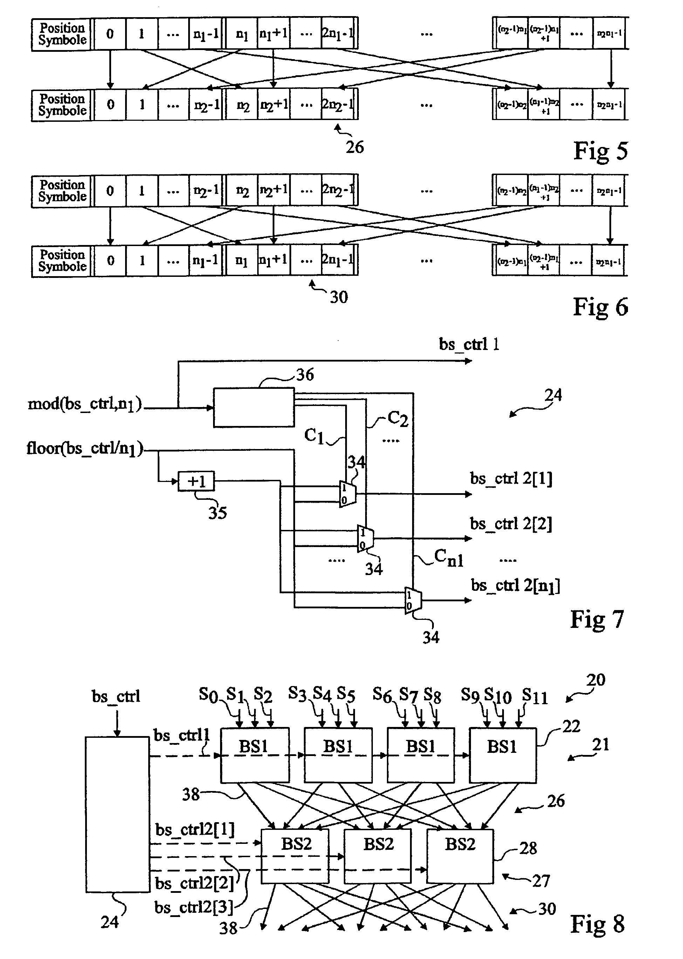

La figure 5 représente un exemple de réalisation de l'étage de réarrangement 26 de la figure 4. On a représenté, sur la ligne supérieure, les positions 0 à $n_2$*$n_1$-1 des symboles reçus par l'étage de réarrangement 26. A des fins de clarté, on a regroupé les positions en groupes de $n_1$ positions, illustrant les groupes de $n_1$ symboles fournis par les dispositifs élémentaires 22. De façon analogue, on a représenté, sur la ligne inférieure, les positions 0 à $n_1$*$n_2$-1 des symboles fournis par l'étage de réarrangement 26. A des fins de clarté, on a regroupé les positions en groupes de $n_2$ positions, illustrant les groupes de $n_2$ symboles fournis aux dispositifs élémentaires 28.

De façon générale, l'étage de réarrangement 26 transmet un symbole reçu à une position i, i étant un entier compris entre 0 et $n_2$*$n_1$-1, à une position j, j étant un entier compris entre 0 et $n_2$*$n_1$-1, selon la relation suivante :

$$j = \mathrm{mod}(i,n_1)*n_2 + \mathrm{floor}(i/n_1)$$

La figure 6 représente un exemple de réalisation de l'étage de réarrangement 30. De façon analogue à ce qui a été décrit en relation à la figure 5, on a regroupé, sur la ligne supérieure, les positions 0 à $n_2$*$n_1$-1 des symboles reçus par l'étage de réarrangement 30 en groupes de $n_2$ positions, illustrant les groupes de $n_2$ symboles fournis par les dispositifs élémentaires 28 et, sur la ligne inférieure, on a regroupé les positions 0 à $n_2$*$n_1$-1 des symboles fournis par l'étage de réarrangement 30 en groupes de $n_1$ positions.

De façon générale, l'étage de réarrangement 30 transmet un symbole reçu à une position i, i étant un entier compris entre 0 et $n_2$*$n_1$-1, à une position j, j étant un entier compris entre 0 et $n_2$*$n_1$-1 selon la relation suivante :

$$j = \mathrm{mod}(i,n_2)*n_1 + \mathrm{floor}(i/n_2)$$

La figure 7 illustre un exemple de réalisation du dispositif de commande 24. La détermination des différents signaux de commande peut être réalisée à partir du signal bs_ctrl en déterminant les signaux mod (bs_ctrl,$n_1$) et floor (bs_ctrl, $n_1$) . Le signal mod(bs_ctrl,$n_1$) correspond directement au signal de commande bs_ctrl1. Le signal floor (bs_ctrl/$n_1$) est transmis à des premières entrées de $n_1$ multiplexeur 34. Un module 35 reçoit également le signal floor(bs_ctrl/$n_1$) auquel il ajoute une unité. La sortie du module 35 attaque les secondes entrées des multiplexeurs 34. Les sorties des $n_1$ multiplexeurs 34 correspondent respectivement aux signaux bs_ctrl2[1] à bs_ctrl2[$n_1$]. Les $n_1$ multiplexeurs 34 sont commandés par $n_1$ signaux de commande $c_1$ à $c_{n1}$ fournis par un module de décodage 36 qui reçoit le signal mod (bs_ctrl,$n_1$). En posant k égal à mod(bs_ctrl,$n_1$), le module de décodage 36 fournit les signaux $c_1$ à $c_k$ mis à 1 et les signaux $c_{k+1}$ à $C_{n1}$ mis à 0.

Le fonctionnement du dispositif de décalage en anneau 20 selon l'exemple de réalisation illustré en figure 4 va maintenant être décrit plus en détails pour un exemple particulier dans lequel $n_1$ = 3 et $n_2$ = 4, c'est-à-dire pour un dispositif de décalage en anneau 20 recevant douze symboles $S_0$ à $S_{11}$ et adapté à réaliser un décalage vers la droite de 0 à 11 positions.

La figure 8 représente la structure d'un tel dispositif de décalage en anneau 20, les étages de réarrangement 26, 30 étant représentés par des trajets 38 reliés à des dispositifs élémentaires 22, 28.

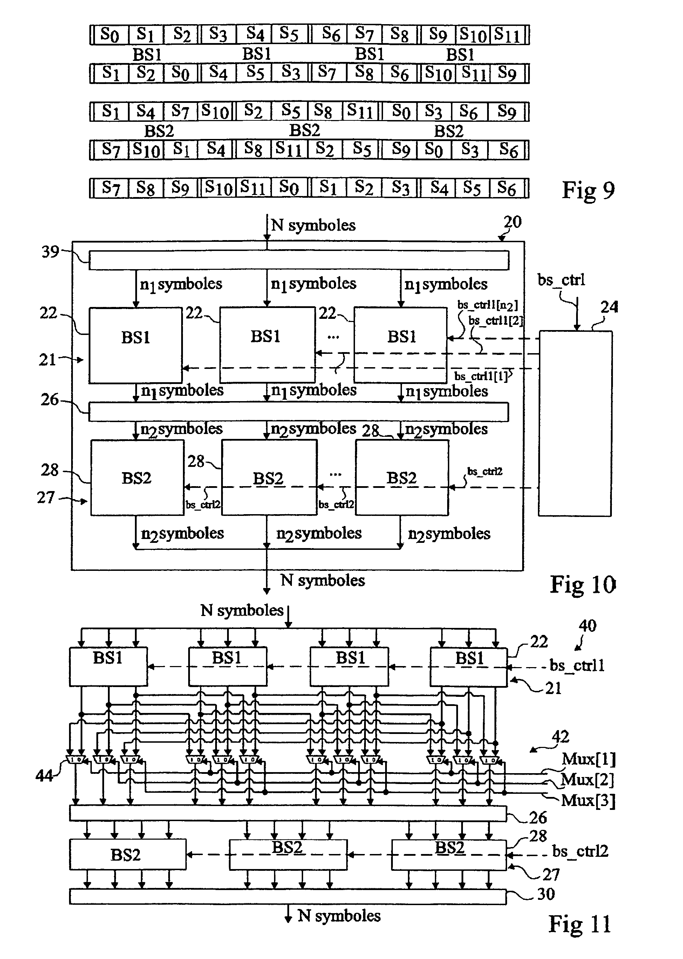

La figure 9 représente les positions occupées par les symboles $S_0$ à $S_{11}$ lors du fonctionnement du dispositif de la figure 8 pour la réalisation d'un décalage vers la droite de cinq positions. Plus précisément, aux première, deuxième, troisième, quatrième et cinquième lignes de la figure 9, on a respectivement représenté les positions relatives des symboles $S_0$ à $S_{11}$ au niveau de :

l'entrée de l'étage 21 de dispositifs élémentaires 22 ;
la sortie de l'étage 21 de dispositifs élémentaires 22 (l'entrée de l'étage de réarrangement 26) ;
la sortie de l'étage de réarrangement 26 (l'entrée de l'étage 27 de dispositifs élémentaires 28) ;
la sortie de l'étage 27 de dispositifs élémentaires 28 (l'entrée de l'étage de réarrangement 30) ; et
la sortie de l'étage de réarrangement 30.

Dans le présent exemple, le signal bs_ctrl est égal à 5. On a alors :

$$\mathtt{bs\_ctrl1 = mod(5,3) = 2}$$

Chaque dispositif élémentaire 22 effectue donc un décalage, sur les trois symboles reçus, de deux positions vers la droite.

Les signaux de commande bs_ctrl2[1], bs_ctrl2[2] et bs_ctrl2[3] sont obtenus de la façon suivante :

$$\mathtt{bs\_ctrl2[1] = bs\_ctrl2[2] = floor(5/3) + 1 = 2}$$

$$\mathtt{bs\_ctrl2[3] = floor(5/3) = 1}$$

Les premier et second dispositifs élémentaires 28 (de gauche à droite en figure 8) réalisent chacun un décalage, sur les quatre symboles qu'il reçoivent, de deux positions vers la droite et le troisième dispositif élémentaire 28 réalise un décalage, sur les quatre symboles qu'il reçoit, d'une position vers la droite.

La dispersion maximale des longueurs des trajets et le nombre maximale de croisements entre trajets sont limités aux étages de réarrangement 26, 30. En effet, les dispositifs élémentaires 22, 28 ne traitant chacun qu'un nombre réduit de symboles, ils ont une dispersion de longueurs de trajet et un nombre de croisements de trajets limités même s'ils ont une structure logarithmique. On limite alors le dépassement de surface lors de la réalisation d'un tel dispositif de décalage en anneau 20. En outre, comme le dispositif 20 est réalisé avec le même nombre de multiplexeurs que pour un dispositif à structure logarithmique, on obtient finalement un dispositif de décalage en anneau qui occupe une surface plus faible que la surface occupée par un dispositif à structure logarithmique.

La figure 10 représente une variante de l'exemple de réalisation du dispositif 20 illustré en figure 4. Par rapport au dispositif 20 représenté en figure 4, l'étage de réarrangement 30 est supprimé. Un étage de réarrangement 39 reçoit les N symboles et fournit $n_2$ groupes de $n_1$ symboles au dispositifs élémentaires 22 du premier étage 21 de dispositifs élémentaires. La structure de l'étage de réarrangement 39 est identique à la structure de l'étage de réarrangement 30 illustrée en figure 6. Les dispositifs élémentaires 22 du premier étage 21 reçoivent des signaux de commande respectifs bs_ctrl1[1] à bs_ctrl1[$n_2$] fournis par le dispositif de commande 24 à partir du signal de commande bs_ctrl. Les dispositifs élémentaires 22 du premier étage 21 de dispositifs élémentaires peuvent donc réaliser des décalages différents sur les groupes de $n_1$ symboles reçus. Chaque dispositif élémentaire 28 du second étage 27 de dispositifs élémentaires reçoit un même signal bs_ctrl2 représentatif du nombre de positions de décalage à réaliser par chaque dispositif élémentaire 28.

Avec l'exemple de réalisation du dispositif de décalage en anneau 20 représenté en figure 10, on peut réaliser un décalage avec rebouclage vers la droite d'un nombre de positions donné par le signal bs_ctrl. Le signal de commande bs_ctrl2 est donné par la relation suivante :

$$\mathtt{bs\_ctrl2 = mod(bs\_ctrl,n_2)}$$

Chaque dispositif élémentaire 28 effectue alors un décalage vers la droite sur les $n_2$ symboles reçus de bs_ctr12 positions.

Les signaux de commande bs_ctrl1[k], pour k entier compris entre 1 et $n_2$, sont donnés par les relations suivantes :

$$\mathtt{bs\_ctrl1[k] = floor(bs\_ctrl/n_2)} \qquad \text{pour } k \le n_2 - bs\_ctrl2$$

$$bs\_ctrl1[k] = floor(bs\_ctrl/n_2) + 1 \quad pour \; k > n_2 - bs\_ctrl2$$

La figure 11 représente un premier exemple de réalisation d'un dispositif de décalage en anneau 40 selon l'invention qui sera décrit pour un exemple particulier dans lequel N = 12, $n_1$ = 3 et $n_2$ = 4. Selon le premier exemple de réalisation, le dispositif 40 comprend, comme pour l'exemple de réalisation représenté en figure 4, les étages 21, 27 de dispositifs élémentaires 22, 28 et les étages de réarrangement 26, 30. De même, les dispositifs élémentaires 22 reçoivent le même signal de commande bs_crlt1. Toutefois, à la différence de l'exemple de réalisation représenté en figure 4, on prévoit, pour le dispositif 40 selon le premier exemple de réalisation, de fournir un signal de commande identique bs_ctr12 à chaque dispositif élémentaire 28. De ce fait, chacun des $n_1$ dispositifs élémentaires 28 réalise le même décalage sur les $n_2$ symboles reçus.

Pour obtenir le décalage souhaité, le dispositif 40 comprend un étage supplémentaire 42 constitué de N modules de multiplexage 44 disposé entre l'étage 21 de dispositifs élémentaires 22 et l'étage de réarrangement 26. Chaque module de multiplexage 44 de l'étage 42 reçoit, à une première entrée, un symbole à une position relative déterminée parmi les $n_1$ symboles fournis par un dispositif élémentaire 22 et, à une seconde entrée, un symbole à la même position relative déterminée parmi les $n_1$ symboles fournis par un dispositif élémentaire 22 adjacent (c'est-à-dire le dispositif élémentaire 28 à gauche dans le présent exemple où un décalage à droite est réalisé, le dispositif "à gauche" du dispositif élémentaire 22 le plus à gauche en figure 11 correspondant au dispositif élémentaire 22 le plus à droite).

Les $n_2$ modules de multiplexage, recevant des symboles fournis par des dispositifs élémentaires 22 adjacents à une même position k relative parmi les $n_1$ symboles fournis par chacun des dispositifs élémentaires 22, sont commandés par un même signal de commande Mux[k]. Dans l'exemple représenté en figure 11, les modules de multiplexage 44, recevant les symboles en première position parmi les trois symboles fournis par chaque dispositif élémentaire 22, sont commandés par un signal de commande Mux[1], les modules de multiplexage 44, recevant les symboles en deuxième position parmi les trois symboles fournis par chaque dispositif élémentaire 22, sont commandés par un signal de commande Mux[2] et les modules de multiplexage 44, recevant les symboles en troisième position parmi les trois symboles fournis par chaque dispositif élémentaire 22, sont commandés par un signal de commande Mux[3].

Les signaux de commande Mux[k], k étant un entier compris entre 1 et $n_1$, sont donnés par les relations suivantes :

$$Mux[k] = 1 \quad pour \; k \leq bs\_ctrl1 \; ;$$

et

$$Mux[k] = 0 \quad pour \; k > bs\_ctrl1$$

Le signal de commande bs_ctrl1 est donné par la relation suivante :

$$bs\_ctrl1 = mod(bs\_ctrl, n_1)$$

et le signal de commande bs_ctrl2 est donné par la relation suivante :

$$bs\_ctrl2 = floor(bs\_ctrl/n_1)$$

En adoptant une structure logarithmique pour les dispositifs élémentaires 22, 28, le dispositif 40 selon le premier exemple de réalisation comporte N*nbit_data multiplexeurs supplémentaires par rapport à un dispositif de décalage en anneau ayant une structure logarithmique. Le dispositif 40 selon le premier exemple de réalisation conserve néanmoins tous les avantages de l'exemple de réalisation illustré en figure 4 dans la mesure où il permet de réduire le dépassement de surface par rapport à un dispositif de décalage en anneau ayant une structure logarithmique.

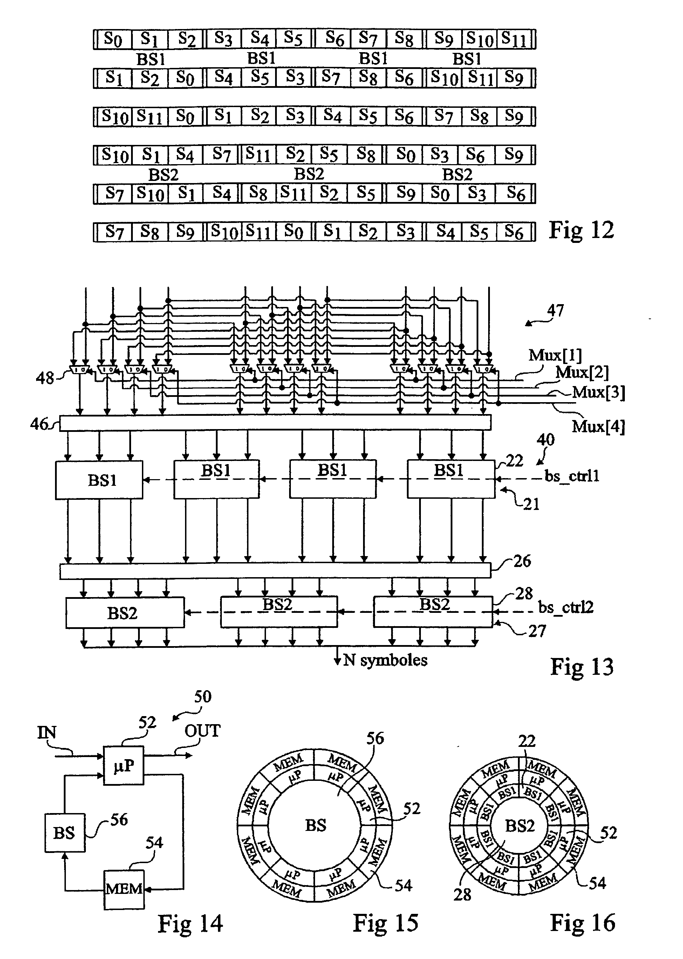

La figure 12 illustre le fonctionnement du dispositif 40 selon le premier exemple de réalisation de l'invention de façon analogue à la figure 9, pour la réalisation d'un décalage de cinq positions vers la droite.

Plus précisément aux première, deuxième, troisième, quatrième, cinquième et sixième lignes de la figure 12, on a respectivement représenté les positions relatives des symboles $S_0$ à $S_{11}$ au niveau de :

l'entrée de l'étage 21 de dispositifs élémentaires 22 ;
la sortie de l'étage 21 de dispositifs élémentaires 22 (l'entrée de l'étage 42 de modules de multiplexage 44) ;
la sortie de l'étage 42 de modules de multiplexage 44 (l'entrée de l'étage de réarrangement 26) ;
la sortie de l'étage de réarrangement 26 (l'entrée de l'étage 27 de dispositifs élémentaires 28) ;
la sortie de l'étage 27 de dispositifs élémentaires 28 (l'entrée de l'étage de réarrangement 30) ; et
la sortie de l'étage de réarrangement 30.

Dans le présent exemple, le signal bs_ctrl est égal à 5. On a alors :

$$\texttt{bs\_ctrl1 = mod(5,3) = 2}$$

Chaque dispositif élémentaire 22 effectue donc un décalage, sur les trois symboles reçus, de deux positions vers la droite. De plus, on a :

$$\texttt{bs\_ctrl2 = floor(5/3) = 1}$$

Chaque dispositif élémentaire 28 effectue donc un décalage, sur les quatre symboles reçus, d'une position vers la droite.

Par ailleurs, on a MUX[1] = MUX[2] = 1 et MUX[3] = 0. Ceci signifie que pour chaque groupe de trois symboles fournis par un dispositif élémentaire 22, le symbole en troisième position n'est pas modifié et les symboles aux première et deuxième positions sont remplacés par les symboles aux première et deuxième positions des trois symboles fournis par le dispositif élémentaire 22 se trouvant à "gauche" du dispositif élémentaire 22 considéré.

Selon une variante du premier exemple de réalisation précédemment décrit, un dispositif élémentaire 22, 28 peut lui-même être réalisé selon le premier exemple de réalisation de l'invention.

La figure 13 représente un second exemple de réalisation du dispositif 40 selon l'invention. Par rapport au premier exemple de réalisation du dispositif 40 représenté en figure 11, l'étage de réarrangement 30 est supprimé. Un étage de réarrangement 46 reçoit les N symboles et fournit $n_2$ groupes de $n_1$ symboles au dispositifs élémentaires 22 du premier étage 21 de dispositifs élémentaires. La structure de l'étage de réarrangement 46 est identique à la structure de l'étage de réarrangement 30 illustrée en figure 6. Un étage supplémentaire 47 constitué de N modules de multiplexage 48 attaque l'étage de réarrangement 46. L'étage 47 a une structure analogue à la structure de l'étage 42 du dispositif 40 représenté en figure 11 dans la mesure où chaque module de multiplexage 48 reçoit, à une première entrée, un symbole à une position relative déterminée parmi un groupe de $n_2$ symboles et, à une seconde entrée, un symbole à la même position relative déterminée parmi un groupe adjacent de $n_2$ symboles (c'est-à-dire le groupe de $n_2$ symboles situé à gauche dans le présent exemple où un décalage à droite est réalisé, le groupe de $n_2$ symboles "à gauche" du groupe de $n_2$ symboles le plus à gauche en figure 13 correspondant au groupe de $n_2$ symboles le plus à droite). Chaque ensemble de $n_1$ modules de multiplexage, recevant des symboles à une même position k relative parmi deux groupes adjacents de $n_2$ symboles, est commandé par un même signal de commande Mux[k].

Les signaux de commande Mux[k], k étant un entier compris entre 1 et $n_2$, sont donnés par les relations suivantes :

$$\texttt{Mux[k] = 0 pour k} \leq \texttt{n}_2 \texttt{ - bs\_ctrl2 ;}$$

et

$$\texttt{Mux[k] = 1 pour k > n}_2 \texttt{ - bs\_ctrl2}$$

Les dispositifs élémentaires 22 reçoivent le même signal de commande bs_crlt1 donné par la relation suivante :

$$\texttt{bs\_ctrl1 = floor(bs\_ctrl/n}_2\texttt{)}$$

et les dispositifs élémentaires 28 reçoivent le même signal de commande bs_ctrl2 donné par la relation suivante :

$$bs\_ctrl2 = mod(bs\_ctrl, n_2)$$

Dans les premier et second exemples de réalisation selon l'invention précédemment décrits, les signaux de commande bs_ctrl1 et bs_ctrl2 sont identiques respectivement pour les dispositifs élémentaires 22 et 26. Ceci permet avantageusement de simplifier la structure du module de commande 24 par rapport à celle illustrée en figure 7 en relation à l'exemple de réalisation de la figure 4.

La figure 14 représente schématiquement un exemple de réalisation d'un décodeur de code LDPC 50. Le décodeur LDPC 50 comprend des processeurs ($\mu$P) 52 fonctionnant en parallèle recevant des symboles IN et fournissant des symboles OUT par un traitement itératif. Pour ce faire, le décodeur 50 comprend une boucle d'itération dans laquelle les symboles sont stockés dans des mémoires (MEM) 54 et sont fournis à nouveau aux processeurs 52 après avoir subi un décalage en anneau réalisé par un dispositif de décalage en anneau (BS) 56. Une telle structure peut aussi être mise en oeuvre pour un décodeur de turbo-codes et, de façon générale, pour un décodeur de codes correcteurs d'erreurs itératifs utilisant un décalage en anneau pour entrelacer des données utilisées en interne.

La figure 15 est une vue de dessus schématique qui illustre un exemple de répartition des éléments du décodeur 50 lorsque le décodeur 50 est réalisé de façon intégrée et que le dispositif de décalage en anneau 56 a une structure logarithmique. Les mémoires 54 sont réparties selon un anneau extérieur et les processeurs 52 selon un anneau intérieur. La région centrale de l'anneau intérieur est occupée par le dispositif de décalage en anneau 56. Avec une structure logarithmique, on doit placer dans la région centrale, N*ceil($\log_2$(N))*nbit_data multiplexeurs et les pistes métalliques associées utilisées pour la réalisation des connexions électriques.

La figure 16 est une vue analogue à la figure 15 lorsque le dispositif de décalage en anneau 56 correspond au premier ou au second exemple de réalisation selon l'invention. Les mémoires 54 et les processeurs 52 sont disposés sous la forme d'anneaux. La présente invention permet de disposer le premier étage 21 de dispositifs élémentaires 22 sous la forme d'un anneau dont la région centrale est occupée par le second étage 27 de dispositifs élémentaires 28 (et éventuellement l'étage 42, 47 de modules de multiplexage 44, 48). Ceci est rendu possible par le fait que le premier étage 21 est constitué de dispositifs élémentaires 22 distincts. Dans la région centrale, on doit alors placer N*ceil($\log_2$($n_2$))*nbit_data multiplexeurs (auxquels s'ajoutent éventuellement les N*nbit_data multiplexeurs de l'étage supplémentaire 42, 47) et les pistes métalliques correspondantes, c'est-à-dire un nombre inférieur au nombre de multiplexeurs à placer pour l'exemple illustré en figure 15, ce qui en simplifie la disposition. Selon une variante, les dispositifs élémentaires 28 peuvent être disposés en anneau à la place des dispositifs élémentaires 22.

Pour réduire au maximum le dépassement de surface, un compromis doit être trouvé pour les valeurs des entiers $n_1$ et $n_2$. En effet, pour diminuer la surface occupée dans la région centrale, l'entier $n_2$ doit être petit. Toutefois, si $n_1$ est trop élevé, les dispositifs élémentaires 22 risquent d'être trop volumineux et la diminution finale du dépassement de surface ne sera pas très importante. Un compromis convenable consiste à choisir $n_1$ peu différent de $n_2$.

Bien entendu, la présente invention est susceptible de diverses variantes et modifications qui apparaîtront à l'homme de l'art. En particulier, des éléments de mémorisation peuvent être prévus entre les deux étages de dispositifs élémentaires. En outre, bien que les dispositifs de décalage en anneau précédemment décrits soient adaptés à la réalisation d'un décalage vers la droite, il est bien clair que la présente invention peut être mise en oeuvre pour la réalisation d'un dispositif de décalage en anneau adapté à la réalisation d'un décalage vers la gauche.

**Revendications**

1.  Dispositif de décalage en anneau (40) adapté à recevoir un nombre N de symboles en parallèle, répartis en un nombre $n_2$ de groupes distincts d'un nombre $n_1$ de symboles, et à appliquer un décalage total en anneau aux N symboles d'un nombre déterminé de positions, le dispositif comprenant :

    $n_2$ premiers dispositifs de décalage en anneau (22), chaque premier dispositif étant adapté à recevoir l'un des groupes distincts de $n_1$ symboles et à appliquer un premier décalage en anneau audit groupe de $n_1$ symboles, le premier décalage dépendant du décalage total ;
    un module de réarrangement (26) adapté à recevoir les N symboles fournis par les premiers dispositifs et à fournir N symboles répartis, de façon déterminée, en $n_1$ ensembles distincts de $n_2$ symboles ;
    $n_1$ seconds dispositifs de décalage en anneau (28), chaque second dispositif étant adapté à recevoir l'un des ensembles distincts de $n_2$ symboles et à appliquer un second décalage en anneau audit ensemble de $n_2$ symboles, le second décalage dépendant du décalage total ; **caractérisé par**
    un module de commande (24) adapté à recevoir un signal bs_ctrl représentatif du décalage total et à fournir, à chaque premier dispositif (22), un signal bs_ctrl1 représentatif du premier décalage qui dépend du décalage total et qui est identique pour chaque premier dispositif, et adapté à fournir, à chaque second dispositif (28), un signal bs_ctrl2 représentatif du second décalage qui dépend du décalage total et qui est identique pour chaque second dispositif ; et

un module de permutation (42 ; 47) adapté à permuter au moins deux symboles parmi les N symboles.

2. Dispositif selon la revendication 1, dans lequel le module de réarrangement (26) est adapté à fournir, pour un symbole reçu à une $i^{\text{ème}}$ position parmi les N symboles fournis par les premiers dispositifs (22), ledit symbole à une $j^{\text{ème}}$ position selon la relation suivante :

$$j = \mathrm{mod}(i,n_1) * n_2 + \mathrm{floor}(i/n_1)$$

où i est un entier compris entre 0 et N-1, $\mathrm{mod}(i,n_1)$ est le reste de la division entière de i par $n_1$ et floor $(i/n_1)$ est le quotient de la division entière de i par $n_1$.

3. Dispositif selon la revendication 1, dans lequel le module de commande (24) est adapté fournir le signal bs_ctrl1 selon la relation suivante :

$$\mathrm{bs\_ctrl1} = \mathrm{mod}(\mathrm{bs\_ctrl},n_1)$$

où $\mathrm{mod}(\mathrm{bs\_ctrl},n_1)$ est le reste de la division entière de bs_ctrl par $n_1$, et adapté à fournir le signal bs_ctrl2 selon la relation suivante :

$$\mathrm{bs\_ctrl2} = \mathrm{floor}(\mathrm{bs\_ctrl}/n_1)$$

où $\mathrm{floor}(\mathrm{bs\_ctrl}/n_1)$ est le quotient de la division entière de bs_ctrl par $n_1$,

le dispositif comprenant, en outre, un module de réarrangement auxiliaire (30) adapté à recevoir les N symboles fournis par les seconds dispositifs (28) et, pour un symbole reçu à une $i^{\text{ème}}$ position, à fournir ledit symbole à une $j^{\text{ème}}$ position selon la relation suivante :

$$j = \mathrm{mod}(i,n_2) * n_1 + \mathrm{floor}(i/n_2)$$

où i est un entier compris entre 0 et N-1, $\mathrm{mod}(i,n_2)$ est le reste de la division entière de i par $n_2$ et $\mathrm{floor}(i/n_2)$ est le quotient de la division entière de i par $n_2$,

le module de permutation (42) comprenant N modules de multiplexage (44), chaque module de multiplexage recevant un premier symbole à une position relative k, k étant un entier compris entre 1 et $n_1$, parmi les $n_1$ symboles fournis par un premier dispositif de décalage en anneau (22) et un second symbole à ladite position relative k parmi les $n_1$ symboles fournis par un premier dispositif de décalage en anneau (22) adjacent et fournissant le second symbole pour k inférieur ou égal à bs_ctrl1 et le premier symbole pour k strictement supérieur à bs_ctrl1.

4. Dispositif selon la revendication 1, dans lequel le module de commande (24) est adapté fournir le signal bs_ctrl1 selon la relation suivante :

$$\mathrm{bs\_ctrl1} = \mathrm{floor}(\mathrm{bs\_ctrl}/n_2)$$

où $\mathrm{floor}(\mathrm{bs\_ctrl}/n_2)$ est le quotient de la division entière de bs_ctrl par $n_2$, et adapté à fournir le signal bs_ctrl2 selon la relation suivante :

$$\mathrm{bs\_ctrl2} = \mathrm{mod}(\mathrm{bs\_ctrl},n_2)$$

où $\mathrm{mod}(\mathrm{bs\_ctrl},n_2)$ est le reste de la division entière de bs_ctrl par $n_2$,

le dispositif comprenant, en outre, un module de réarrangement auxiliaire (46) adapté à recevoir les N symboles et à fournir les N symboles aux premiers dispositifs (22) de façon que, pour un symbole reçu à une $i^{ème}$ position, ledit symbole est fourni à une $j^{ème}$ position selon la relation suivante :

$$j = \mathrm{mod}(i,n_2)*n_1 + \mathrm{floor}(i/n_2)$$

où i est un entier compris entre 0 et N-1, $\mathrm{mod}(i,n_2)$ est le reste de la division entière de i par $n_2$ et floor $(i/n_2)$ est le quotient de la division entière de i par $n_2$,

le module de permutation (47) comprenant N modules de multiplexage (48), chaque module de multiplexage recevant un premier symbole à une position relative k, k étant un entier compris entre 1 et $n_2$, dans un groupe de $n_2$ symboles parmi les N symboles reçus par ledit dispositif et un second symbole à ladite position relative k dans un groupe adjacent de $n_2$ symboles et fournissant, au module de réarrangement auxiliaire, le premier symbole pour k inférieur ou égal à la différence entre $n_2$ et bs_ctrl2 et le second symbole pour k strictement supérieur à la différence entre $n_2$ et bs_ctrl2.

5. Décodeur de code (50) comprenant des processeurs (52) reliés à des éléments de mémorisation (54) et à un dispositif de décalage en anneau (56) selon l'une quelconque des revendications 1 à 4, dans lequel les processeurs et les éléments de mémorisation sont disposés selon des premier et second anneaux concentriques et dans lequel les premiers ou les seconds dispositifs (22) du dispositif de décalage en anneau sont répartis selon un troisième anneau concentrique aux premier et second anneaux.

**Claims**

1. A barrel shifter (40) arranged to receive a number N of symbols in parallel, arranged in a number $n_2$ of distinct groups of a number $n_1$ of symbols, and to apply a total circular shift to the N symbols of a determined number of positions, the barrel shifter comprising:

   $n_2$ first barrel shifters (22), each first barrel shifter being adapted to receive one of the distinct groups of $n_1$ symbols and to apply a first circular shift to said group of $n_1$ symbols, the first shift depending on the total shift; a rearrangement module (26) adapted to receive the N symbols provided by the first barrel shifters and to provide N symbols arranged, in a determined manner, in $n_1$ distinct groups of $n_2$ symbols; $n_1$ second barrel shifters (28), each second barrel shifter being adapted to receive one of the distinct groups of $n_2$ symbols and to apply a second circular shift to said group of $n_2$ symbols, the second shift depending on the total shift;

   **characterized by**:

   a control module (24) adapted to receive a signal bs_ctrl representing a total shift and to provide, to each first barrel shifter (22), a signal bs_ctrl1 representing the first shift that depends on the total shift and which is identical for each first barrel shifter, and adapted to provide, to each second barrel shifter (28), a signal bs_ctrl2 representing the second shift which depends on the total shift and which is identical for each second barrel shifter; and a switching module (42; 47) adapted to switch at least two of the symbols of the N symbols.

2. The barrel shifter according to claim 1, wherein the rearrangement module (26) is adapted to provide, for a symbol received at an $i^{th}$ position in the N symbols provided by the first barrel shifters (22), said symbol at a $j^{th}$ position according to the following relationship:

$$j = \mathrm{mod}(i,n_1)*n_2 + \mathrm{floor}(i/n_1)$$

where i is an integer between 0 and N-1, $\mathrm{mod}(i,n_1)$ is the remainder of the whole division of i by $n_1$ and $\mathrm{floor}(i/n_1)$ is the quotient of the whole division of i by $n_1$.

3. The barrel shifter according to claim 1, wherein the control module (24) is adapted to provide the signal bs_ctrl1 according to the following relationship:

$$bs\_ctrl1 = mod(bs\_ctrl, n_1)$$

where $mod(bs\_ctrl, n_1)$ is the remainder of the whole division of $bs\_ctrl$ by $n_1$, and adapted to provide the signal $bs\_ctrl2$ according to the following relationship:

$$bs\_ctrl2 = floor(bs\_ctrl/n_1)$$

where $floor(bs\_ctrl/n_1)$ is the quotient of the whole division of $bs\_ctrl$ by $n_1$,
the barrel shifter further comprising an auxiliary rearrangement module (30) adapted to receive the N symbols provided by the second barrel shifters (28) and, for a symbol received at an $i^{th}$ position, to provide said symbol at a $j^{th}$ position according to the following relationship:

$$j = mod(i, n_2) * n_1 + floor(i/n_2)$$

where i is an integer between 0 and N-1, $mod(i, n_2)$ is the remainder of the whole division of i by $n_2$, and $floor(i/n_2)$ is the quotient of the whole division of i by $n_2$,
the switching module (42) comprising N multiplexing modules (44), each multiplexing module receiving a first symbol at a relative position k, k being an integer between 1 and $n_1$, of the $n_1$ symbols provided by a first barrel shifter (22) and a second symbol at said relative position k of the $n_1$ symbols provided by a first adjacent barrel shifter (22) and providing the second symbol when k is less than or equal to $bs\_ctrl1$ and the first symbol when k is greater than $bs\_ctrl1$.

4. The barrel shifter according to claim 1, wherein the control module (24) is adapted to provide the signal $bs\_ctrl1$ according to the following relationship:

$$bs\_ctrl1 = floor(bs\_ctrl/n_2)$$

where $floor(bs\_ctrl/n_2)$ is the quotient of the whole division of $bs\_ctrl$ by $n_2$, and adapted to provide the signal $bs\_ctrl2$ according to the following relationship:

$$bs\_ctrl2 = mod(bs\_ctrl, n_2)$$

where $mod(bs\_ctrl, n_2)$ is the remainder of the whole division of $bs\_ctrl$ by $n_2$,
the barrel shifter further comprising an auxiliary rearrangement module (46) adapted to receive the N symbols and to provide the N symbols to the first barrel shifters (22) such that, for a symbol received at an $i^{th}$ position, said symbol is provided at a $j^{th}$ position according to the following relationship:

$$j = mod(i, n_2) * n_1 + floor(i/n_2)$$

where i is an integer between 0 and N-1, $mod(i, n_2)$ is the remainder of the whole division of i by $n_2$, and $floor(i/n_2)$ is the quotient of the whole division of i by $n_2$,
the switching module (47) comprising N multiplexing modules (48), each multiplexing module receiving a first symbol at a relative position k, k being an integer between 1 and $n_2$, in the group of $n_2$ symbols amongst the N symbols received by said barrel shifter, and a second symbol at said relative position k in an adjacent group of $n_2$ symbols and providing, to the auxiliary rearrangement module, the first symbol when k is less than or equal to the difference between $n_2$ and $bs\_ctrl2$ and the second symbol when k is greater than the difference between $n_2$ and $bs\_ctrl2$.

5. A decoder (50) comprising processors (52) connected to memory elements (54) and to a barrel shifter (56) according to any of the claims 1 to 4, wherein the processors and the memory elements are arranged in first and second concentric rings and in which the first or second barrel shifters (22) of the barrel shifter are arranged in a third ring concentric to the first and second rings.

**Patentansprüche**

1. Ein Barrel-Shifter (40), der angeordnet ist, um eine Anzahl N von Symbolen parallel zu empfangen, und zwar angeordnet in einer Anzahl $n_2$ von unterschiedlichen Gruppen von einer Anzahl von $n_1$ von Symbolen und um eine gesamte zirkulare Verschiebung für die N Symbole um einer bestimmten Anzahl von Positionen anzuwenden, wobei der Barrel-Shifter Folgendes aufweist:

   $n_2$ erste Barrel-Shifter (22), wobei jeder erste Barrel-Shifter angepasst ist zum Empfangen einer von den unterschiedlichen Gruppen von $n_1$ Symbolen und zum Anwenden einer ersten zirkularen Verschiebung auf die Gruppe von $n_1$ Symbolen, wobei die erste Verschiebung von der gesamten Verschiebung abhängt;
   ein Umordnungsmodul (26), das angepasst ist zum Empfangen der N Symbole, die durch die ersten Barrel-Shifter vorgesehen sind, und zum Vorsehen von N Symbolen, die auf eine vorbestimmte Weise in $n_1$ unterschiedlichen Gruppen von $n_2$ Symbolen angeordnet sind;
   $n_1$ zweite Barrel-Shifter (28), wobei jeder zweite Barrel-Shifter angepasst ist zum Empfangen einer von den unterschiedlichen Gruppen von $n_2$ Symbolen und zum Anwenden einer zweiten zirkularen Verschiebung auf die Gruppe von $n_2$ Symbolen, wobei die zweite Verschiebung von der gesamten Verschiebung abhängt;

   **gekennzeichnet durch**:

   ein Steuermodul (24), das angepasst ist zum Empfangen eines Signals bs_ctrl das eine gesamte Verschiebung repräsentiert und zum Vorsehen für jeden ersten Barrel-Shifter (22) ein Signal bs_ctrl1 das die erste Verschiebung repräsentiert, die abhängt von der gesamten Verschiebung und die für jeden ersten Barrel-Shifter identisch ist und angepasst ist zum Vorsehen an jeden zweiten Barrel-Shifter (28) ein Signal bs_ctrl2, das die zweite Verschiebung repräsentiert, die abhängt von der gesamten Verschiebung und die für jeden zweiten Barrel-Shifter identisch ist; und
   ein Schaltmodul (42; 47) das angepasst ist zum Schalten bzw. Austauschen von wenigstens zwei der Symbole von den N Symbolen.

2. Barrel-Shifter nach Anspruch 1, wobei das Umordnungsmodul (26) angepasst ist, um für ein Symbol, das an einer i-ten Position in den N Symbolen empfangen wird, die durch die ersten Barrel-Shifter (22) vorgesehen sind, das Symbol an einer j-ten Position gemäß der folgenden Beziehung, vorzusehen:

$$j = mod(i, n_1) * n_2 + floor(i/n_1)$$

wobei i eine ganze Zahl zwischen 0 und N-1 ist, $mod(i, n_1)$ der Rest von der gesamten Division von i durch $n_1$ ist und $floor(i/n_1)$ der Quotient von der gesamten Division von i durch $n_1$ ist.

3. Barrel-Shifter gemäß Anspruch 1, wobei das Steuermodul (24) angepasst ist zum Vorsehen des Signals bs_ctrl1 gemäß der folgenden Beziehung:

$$bs\_ctrl1 = mod(bs\_ctrl, n_1)$$

wobei $mod(bs\_ctrl, n_1)$ der Rest von der gesamten Division von bs_ctrl durch $n_1$ ist, und angepasst ist zum Vorsehen des Signals bs_ctrl2 gemäß der folgenden Beziehung:

$$bs\_ctrl2 = floor(bs\_ctrl/n_1)$$

wobei $floor(bs\_ctrl/n_1)$ der Quotient von der gesamten Division von bs_ctrl durch $n_1$ ist,

der Barrel-Shifter ferner ein Hilfsumordnungsmodul (30) aufweist, das angepasst ist zum Empfangen der N Symbole die durch die zweiten Barrel-Shifter (28) vorgesehen sind, und für ein an einer i-ten Position empfangenes Symbol, Vorsehen des Symbols an einer j-ten Position gemäß der folgenden Beziehung:

$$j = mod(i, n_2)^* \, n_1 + floor(i/n_2)$$

wobei i eine ganze Zahl zwischen 0 und N-1 ist, $mod(i, n_2)$ der Rest von der gesamten Division von i durch $n_2$ ist und $floor(i/n_2)$ der Quotient von der gesamten Division von i durch $n_2$ ist,
das Schaltmodul (42) N Multiplexmodule (44) aufweist, wobei jedes Multiplexmodul ein erstes Symbol an einer relativen Position k empfängt, wobei k eine ganze Zahl zwischen 1 und $n_1$ ist und zwar von den $n_1$ Symbolen die durch einen ersten Barrel-Shifter (22) vorgesehen sind und ein zweites Symbol empfängt an der relativen Position k von den $n_1$ Symbolen, Vorgesehen durch einen ersten benachbarten Barrel-Shifter (22), und Vorsehen des zweiten Symbols, wenn k kleiner oder gleich wie bs_ctrl1 ist und Vorsehen des ersten Symbols, wenn k größer als bs_ctrl1 ist.

4. Barrel-Shifter nach Anspruch 1, wobei das Steuermodul (24) angepasst ist zum Vorsehen des Signals bs_ctrl1 gemäß der folgenden Beziehung:

$$bs\_ctrl1 = floor(bs\_ctrl/n_2)$$

wobei $floor(bs\_ctrl/n_2)$ der Quotient von der gesamten Division von bs_ctrl durch $n_2$ ist, und angepasst ist zum Vorsehen des Signals bs_ctrl2 gemäß der folgenden Beziehung:

$$bs\_ctrl2 = mod(bs\_ctrl, n_2)$$

wobei $mod(bs\_ctrl, n_2)$ der Rest von der gesamten Division von bs_ctrl durch $n_2$ ist,
wobei der Barrel-Shifter ferner ein Hilfsumordnungsmodul (46) aufweist, das angepasst ist zum Empfangen der N Symbole und zum Vorsehen der N Symbole an die ersten Barrel-Shifter (22) so dass für ein an einer i-ten Position empfangenes Symbol das Symbol an einer j-ten Position gemäß der folgenden Beziehung vorgesehen ist:

$$j = mod(i, n_2) * n_1 + floor(i/n_2)$$

wobei i eine ganze Zahl zwischen 0 und N-1 ist, $mod(i, n_2)$ der Rest von der gesamten Division von i durch $n_2$ ist, und $floor(i/n_2)$ der Quotient von der gesamten Division von i durch $n_2$ ist,
das Schaltmodul (47) N Multiplexmodule (48) aufweist, wobei jedes Multiplexmodul ein erstes Symbol an einer relativen Position k empfängt,
wobei k eine ganze Zahl zwischen 1 und $n_2$ ist, und zwar in der Gruppe von $n_2$ Symbolen aus den durch den Barrel-Shifter empfangenen N Symbolen und ein zweites Symbol empfängt an der relativen Position k in einer benachbarten Gruppe von $n_2$ Symbolen und an das Hilfsumordnungsmodul das erste Symbol vorsieht, wenn k weniger ist als die oder gleich ist der Differenz zwischen $n_2$ und bs_ctrl2 und das zweite Symbol vorsieht, wenn k größer ist als die Differenz zwischen $n_2$ und bs_ctrl2.

5. Ein Decodierer (50) der Prozessoren (52) aufweist, die mit Speicherelementen (54) und mit einem Barrel-Shifter (56) gemäß irgendeinem der Ansprüche 1 bis 4 verbunden ist, wobei die Prozessoren und die Speicherelemente angeordnet sind in ersten und zweiten konzentrischen Ringen und bei dem die ersten und zweiten Barrel-Shifter (22) von dem Barrel-Shifter in einem dritten Ring, der zu den ersten und zweiten Ringen konzentrisch ist, angeordnet sind.

bs_ctrl → [BS] 10

12

14

**Fig 1**

| $S_0$ | $S_1$ | $S_2$ | $S_3$ | $S_4$ | $S_5$ | $S_6$ | $S_7$ |

| $S_5$ | $S_6$ | $S_7$ | $S_0$ | $S_1$ | $S_2$ | $S_3$ | $S_4$ |

**Fig 2**

$S_0$  $S_1$  $S_2$  $S_3$  $S_4$  $S_5$  $S_6$  $S_7$   10

bs_ctrl(0) → 15

bs_ctrl(1) → 16

19

bs_ctrl(2) → 17

18

**Fig 3**

N symboles   20

$n_1$ symboles   $n_1$ symboles   $n_1$ symboles

bs_ctrl

24

22   BS1   22   BS1   ···   BS1   bs_ctrl1

21   bs_ctrl1   bs_ctrl1

$n_1$ symboles   $n_1$ symboles   $n_1$ symboles

26

$n_2$ symboles   $n_2$ symboles 28   $n_2$ symboles

bs_ctrl2[$n_1$]

bs_ctrl2[2]

28   BS2   28   BS2   ···   BS2

27   bs_ctrl2[1]

$n_2$ symboles   $n_2$ symboles   $n_2$ symboles

30

N symboles

**Fig 4**

Fig 5

Fig 6

Fig 7

Fig 8

| S0 | S1 | S2 | S3 | S4 | S5 | S6 | S7 | S8 | S9 | S10 | S11 |

BS1  BS1  BS1  BS1

| S1 | S2 | S0 | S4 | S5 | S3 | S7 | S8 | S6 | S10 | S11 | S9 |

| S1 | S4 | S7 | S10 | S2 | S5 | S8 | S11 | S0 | S3 | S6 | S9 |

BS2  BS2  BS2

| S7 | S10 | S1 | S4 | S8 | S11 | S2 | S5 | S9 | S0 | S3 | S6 |

| S7 | S8 | S9 | S10 | S11 | S0 | S1 | S2 | S3 | S4 | S5 | S6 |

**Fig 9**

**Fig 10**

**Fig 11**

| S0 | S1 | S2 | S3 | S4 | S5 | S6 | S7 | S8 | S9 | S10 | S11 |
|---|---|---|---|---|---|---|---|---|---|---|---|

BS1     BS1     BS1     BS1

| S1 | S2 | S0 | S4 | S5 | S3 | S7 | S8 | S6 | S10 | S11 | S9 |
|---|---|---|---|---|---|---|---|---|---|---|---|

| S10 | S11 | S0 | S1 | S2 | S3 | S4 | S5 | S6 | S7 | S8 | S9 |
|---|---|---|---|---|---|---|---|---|---|---|---|

| S10 | S1 | S4 | S7 | S11 | S2 | S5 | S8 | S0 | S3 | S6 | S9 |
|---|---|---|---|---|---|---|---|---|---|---|---|

BS2     BS2     BS2

| S7 | S10 | S1 | S4 | S8 | S11 | S2 | S5 | S9 | S0 | S3 | S6 |
|---|---|---|---|---|---|---|---|---|---|---|---|

| S7 | S8 | S9 | S10 | S11 | S0 | S1 | S2 | S3 | S4 | S5 | S6 |
|---|---|---|---|---|---|---|---|---|---|---|---|

Fig 12

Fig 13

Fig 14

Fig 15

Fig 16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **BRACKENBURY L E M ; WELLS P J ; GOSLING J B.** UNIVERSAL SHIFT MATRIX''; IEE PROCEEDINGS E. COMPUTERS & DIGITAL TECHNIQUES. INSTITUTION OF ELECTRICAL ENGINEERS, vol. 137, 57-64